# EUROPÄISCHE PATENTSCHRIFT

(11) **EP 2 609 613 B1**
(45) Veröffentlichungstag und Bekanntmachung des Hinweises auf die Patenterteilung: **16.03.2016**
(21) Anmeldenummer: 11752118.7
(22) Anmeldetag: 26.08.2011
(51) Int. Cl.: H01J 37/32, H05H 1/46

(54) **VERFAHREN UND VORRICHTUNG ZUM BEHANDELN EINES SUBSTRATS MITTELS EINES PLASMAS**
METHOD AND DEVICE FOR TREATING A SUBSTRATE BY MEANS OF A PLASMA
PROCÉDÉ ET DISPOSITIF POUR TRAITER UN SUBSTRAT PAR PLASMA

(30) Priorität: 27.08.2010 DE 102010035593
(43) Veröffentlichungstag der Anmeldung: 03.07.2013
(73) Patentinhaber: HQ-Dielectrics GmbH, 89156 Dornstadt (DE)
(72) Erfinder: NIESS, Jürgen, 89567 Sontheim (DE); BECKMANN, Wilhelm, 33098 Paderborn (DE)
(74) Vertreter: Klang, Alexander H.
(86) Internationale Anmeldenummer: PCT/EP2011/004310
(87) Internationale Veröffentlichungsnummer: WO 2012/025248

(56) Entgegenhaltungen:
- EP-A2- 0 817 237
- DE-A1- 19 634 795
- JP-A- 61 265 820
- US-A- 5 639 519
- US-A1- 2003 168 172

## Beschreibung

Die vorliegende Erfindung betrifft ein Verfahren und eine Vorrichtung zum Behandeln eines Substrats mittels eines Plasmas.

In unterschiedlichen technischen Gebieten ist es bekannt, Substrate mittels eines Plasmas zu behandeln. Insbesondere in der Halbleitertechnologie ist es bekannt mittels eines Plasmas eine Oberfläche eines Substrats zu ätzen oder bei einem Schichtaufbau durch eine z.B. plasmaunterstützten Oxidation ein SiOₓN_{y} Fim zu wachsen oder eine Abscheidung aus der Dampfphase mittels eines Plasmas zu unterstützen (PECVD = Plasma Enhanced Chemical Vapor Deposition).

Die für die Behandlung von Substraten eingesetzten Plasmaeinheiten besitzen jeweils eine wesentlich höhere Zündleistung, als eine Leistung die zur Aufrechterhaltung eines einmal gezündeten Plasmas erforderlich ist. Mithin muss eine entsprechende Plasmaeinheit zum anfänglichen Zünden eines Plasmas mit einer hohen Leistung gespeist werden, die anschließend auf ein Niveau reduziert wird, mit dem das Plasma für die Behandlung des Substrats gespeist wird.

Dabei ergibt sich das Problem, das sich bei der Zündung des Plasmas eine Plasma-Druckwelle mit hoher Energie ergeben kann. Darüber hinaus liegen unmittelbar nach der Zündung sehr hohe Energien der Plasmateilchen vor, was zu einer Schädigung der zu behandelnden Substratoberfläche führen kann. Darüber hinaus stellt sich bei einem einem SiOₓN_{y} Filmwachstum oder PECVD-Verfahren zunächst eine sehr hohe Wachstumsrate ein, die mit der eingespeisten hohen Zündleistung in Korrelation steht. Eine solche hohe Wachstumsrate führt jedoch zu einer nicht optimalen Schichtzusammensetzung und einem nicht optimalen Schichtaufbau, wie es auch schon von Eisele, A. Ludsteck, J. Schulze, Z. Nenyei in 10th IEEE International Conference on Advanced Thermal Processing of Semiconductors - RTP2002, Vancouver, Canada, ISBN 0-7803-7465-7, (2002), Seiten 11-1, beschrieben wurde.

Eine Möglichkeit, die Auswirkungen dieses Effekts auf das Substrat zu minimieren, ist eine Abstandsvariation zwischen der Plasmaeinheit und dem zu behandelnden Substrat, sodass ein Plasma zunächst bei großem Abstand gezündet wird und anschließend, nachdem die Plasmaleistung auf ein niedrigeres Behandlungsniveau eingestellt wurde, der Abstand verringert wird, wie es in der nicht veröffentlichten DE 2009060230.5 beschrieben ist. Hierzu ist jedoch ein entsprechender apparativer Aufbau notwendig, um die Abstandseinstellung zu ermöglichen.

Weiterhin wird auf die EP 0 817 237 A2 hingewiesen, die eine Plasma-Behandlungsvorrichtung zeigt, bei der ein HF-Plasma über eine erste außerhalb einer Behandlungskammer liegende Elektrode gezündet und über eine zweite Elektrode während einer Behandlung aufrecht gehalten wird. Die EP 0 817 237 A2 zeigt auch ein Verfahren und eine Vorrichtung gemäß dem Oberbegriff der Ansprüche 1 und 11.

Ausgehend von dem oben genannten Stand der Technik liegt der vorliegenden Erfindung die Aufgabe zugrunde, negative Einflüsse, die bei der Zündung eines Plasmas auf ein Substrat entstehen können, zu verhindern, oder zumindest zu verringern.

Erfindungsgemäß wird diese Aufgabe durch ein Verfahren nach Anspruch 1 und eine Vorrichtung nach Anspruch 11 gelöst. Weitere Ausgestaltungen der Erfindung ergeben sich aus den Unteransprüchen.

Insbesondere wird bei dem Verfahren ein Plasma über eine Vielzahl von Plasmaeinheiten erzeugt, wobei zunächst in wenigstens eine erste Plasmaeinheit, eine Zündleistung eingespeist wird, um benachbart hierzu in einem ersten Plasmabereich ein Plasma zu erzeugen. Anschließend oder auch gleichzeitig hierzu wird in wenigstens einer zweiten Plasmaeinheit eine Leistung eingespeist, die wesentlich kleiner ist als die Zündleistung der zweiten Plasmaeinheit, die aber ausreicht, um ein einmal gezündetes Plasma benachbart zur zweiten Plasmaeinheit aufrecht zu erhalten, wobei die zweite Plasmaeinheit derart benachbart zur ersten Plasmaeinheit liegt, das der erste Plasmabereich einen Abstrahlbereich der zweiten Plasmaeinheit überlappt. Mittels des schon gezündeten Plasmas im ersten Plasmabereich und der in die zweite Plasmaeinheit eingespeisten Leistung wird nun ein Plasma im Plasmabereich der zweiten Plasmaeinheit gezündet. Die zweite Plasmaeinheit kann somit mit einer Leistungseinspeisung gezündet werden, die weit unter ihrer eigentlichen Zündleistung liegt, da sich im Abstrahlbereich der zweiten Plasmaeinheit schon ein Plasma, nämlich das der ersten Plasmaeinheit ausgebildet hat. Somit entstehen bei der Zündung der zweiten Plasmaeinheit keine hochenergetischen Plasmakomponenten, und auch keine entsprechende Druckwelle, wie sie ansonsten entstehen würden, wenn die zweite Plasmaeinheit mit ihrer Zündleistung gespeist worden wäre. Die Angabe, wonach die in die zweite Plasmaeinheit eingespeiste Leistung wesentlich kleiner ist als deren Zündleistung, soll den Fall umfassen, bei dem die eingespeiste Leistung maximal 70% der Zündleistung beträgt. Vorzugsweise sollte die eingespeiste Leistung maximal 50% der Zündleistung betragen und insbesondere sollte die eingespeiste Leistung kleiner gleich 20%, oder gar kleiner gleich 10% der Zündleistung der zweiten Plasmaeinheit betragen. Hierdurch ergibt sich eine sanfte Zündung des Plasmas zur Behandlung des Substrats.

Vorzugsweise wird in wenigstens einer weiteren Plasmaeinheit eine Leistung eingespeist, die wesentlich kleiner ist als die Zündleistung der weiteren Plasmaeinheit, die aber ausreicht, um ein einmal gezündetes Plasma benachbart zur weiteren Plasmaeinheit aufrechtzuerhalten, wobei die weitere Plasmaeinheit derart benachbart zur ersten oder zweiten Plasmaeinheit liegt, das deren Plasmabereich einen Abstrahlbereich der weiteren Plasmaeinheit überlappt. Hierdurch wird ein Plasma im Plasmabereich der weiteren Plasmaeinheit mittels des gezündeten Plasmas im Plasmabereich der ersten oder zweiten Plasmaeinheit und der in die weitere Plasmaeinheit eingespeisten Leistung gezündet. Hierdurch kann das Plasma weiter ausgedehnt werden, bis das gesamte Substrat mit Plasma abgedeckt wird. Hochenergetische Plasmakomponenten entstehen wenn überhaupt nur beim Zünden der ersten Plasmaeinheit, und alle nachfolgenden Plasmaeinheiten können mit einer wesentlich geringeren Leistung gezündet werden, da jeweils benachbart hierzu ein gezündetes Plasma vorgesehen ist, das den entsprechenden Abstrahlbereich der Plasmaeinheit überlappt. Gemäß der Erfindung liegt ferner die wenigstens eine erste Plasmaeinheit außerhalb eines Projektionsbereichs des zu behandelnden Substrats. Hierdurch können Auswirkungen der ersten Zündung auf die Oberfläche des Substrats verhindert oder zumindest verringert werden. Um Auswirkungen der ersten Zündung auf die Oberfläche des Substrats zu verringern ist auch vorgesehen, dass die erste Plasmaeinheit eine Zündleistung besitzt, die wesentlich kleiner ist als die Zündleistung der wenigstens einen zweiten oder weiteren Plasmaeinheiten. Die erste Plasmaeinheit kann somit als designierte Zündeinheit angesehen werden, die hinsichtlich ihrer Leistung kleiner ausgebildet sein kann als die eigentlichen für die Behandlung eingesetzten Plasmaeinheiten. Als wesentlich kleinere Zündleistung wird eine Zündleistung der ersten Plasmaeinheit angesehen, die maximal 70% der Zündleistung der wenigstens einen zweiten oder weiteren Plasmaeinheiten, vorzugsweise maximal 50% und insbesondere weniger als 20%, oder gar kleiner gleich 10% der Zündleistung der wenigstens einen zweiten oder weiteren Plasmaeinheiten aufweist.

Bei einer Ausführungsform der Erfindung wird eine Vielzahl von Plasmaeinheiten sequentiell in der obigen Art und Weise von einer Seite des zu behandelnden Substrats zur gegenüberliegenden Seite hin gezündet. Hierdurch kann eine gerichtete Druckwelle über das Substrat hinweg erzeugt werden, um gegebenenfalls Verunreinigungen hiervon zu lösen und abzutransportieren. Dabei sei bemerkt, dass die Druckwelle gegenüber einer normalen Zünddruckwelle wesentlich kleiner ist. In ähnlicher Weise ist es auch möglich, dass eine Vielzahl von Plasmaeinheiten beispielsweise sequentiell von der Mitte des zu behandelnden Substrats in entgegengesetzte Richtungen zum Rand des Substrats in der obigen Weise gezündet wird. Hierdurch würden zwei in entgegengesetzte Richtungen laufende Druckwellen erzeugt.

Gemäß einer Ausführungsform liegt die wenigstens eine erste Plasmaeinheit weiter von der zu behandelnden Oberfläche des Substrats entfernt ist als eine zweite oder weitere Plasmaeinheit. Hierdurch können Auswirkungen der ersten Zündung auf die Oberfläche des Substrats weiter verhindert oder zumindest verringert werden.

Bei einer Ausführungsform wird wenigstens ein Teil der Plasmaeinheiten während der Behandlung eines Substrats gepulst betrieben, wobei jeweils für eine erneute Zündung eines Plasmas im jeweiligen Plasmabereich einer gepulsteten Plasmaeinheit diese mit einer Leistung beaufschlagt wird, die wesentlich kleiner ist als die Zündleistung der entsprechenden Plasmaeinheit, die aber ausreicht, ein einmal gezündetes Plasma benachbart zur Plasmaeinheit aufrechtzuerhalten, wobei die Zündung jeweils über ein bestehendes benachbartes Plasma und die jeweils eingespeiste Leistung erfolgt. Das Pulsen der Plasmaeinheit sorgt unter anderem für eine raschere Erfrischung der reaktiven Spezies. Durch die spezielle Zündung mit einer geringeren Leistung als der Zündleistung kann die durchschnittliche Leistung während des Plasmabetriebs wesentlich verringern, und ermöglicht darüber hinaus ein schnelleres Pulsen des Plasmas. Bei dem gepulsteten Betrieb wenigstens eines Teils der Plasmaeinheiten ist es möglich wenigstens eine Plasmaeinheit insbesondere die wenigstens eine erste Plasmaeinheit kontinuierlich zu betreiben, sodass jeweils ein Plasma besteht, an dem sich die anderen Plasmaeinheiten entzünden können. Insbesondere ist es möglich, die erste Plasmaeinheit so anzuordnen, dass sich deren Plasmabereich über die Abstrahlbereiche aller anderen Plasmaeinheiten erstreckt, sodass diese auch ein im Wesentlichen gleichzeitiges Zünden aller anderen Plasmaeinheiten ermöglicht. Natürlich ist es auch möglich mehrere Plasmaeinheiten vorzusehen, um unterschiedliche Zündvorgänge vorsehen zu können.

Bei der Vorrichtung zum Behandeln eines Substrats mittels eines Plasmas ist eine Vielzahl von benachbarten Plasmaeinheiten zum jeweiligen Erzeugen eines Plasmas in einem Plasmabereich der Plasmaeinheiten vorgesehen, wobei die Plasmaeinheiten so angeordnet sind, dass der Plasmabereich wenigstens einer ersten Plasmaeinheit einen Abstrahlbereich wenigstens einer zweiten Plasmaeinheit überlappt. Ferner ist eine Steueranordnung vorgesehen, die geeignet ist, wenigstens die ersten und zweiten Plasmaeinheiten unabhängig voneinander anzusteuern. Eine solche Vorrichtung ermöglicht die Durchführung eines Verfahrens wie oben beschrieben mit den damit verbundenen Vorteilen. Die Steuereinheit kann aber auch jede einzelne Plasmaeinheit unabhängig von den anderen so steuern werden, dass sich neben einer räumlichen auch eine zeitliche Verzögerung ergibt. Dabei weist die wenigstens eine erste Plasmaeinheit eine Zündleistung auf, die wesentlich kleiner ist als die Zündleistung der wenigstens einen zweiten Plasmaeinheit, wodurch bei einer Zündung eines Plasmas im Bereich der ersten Plasmaeinheit die Erzeugung hochenergetischer Plasmakomponenten reduziert werden kann. Die eine erste Plasmaeinheit liegt außerhalb eines Projektionsbereichs des zu behandelnden Substrats. Sie kann zusätzlich auch weiter von der behandelnden Oberfläche des Substrats entfernt sein als die wenigstens eine zweite Plasmaeinheit.

Vorzugsweise ist eine Vielzahl von zweiten Plasmaeinheiten vorgesehen, die benachbart derart angeordnet sind, dass ein jeweiliger Plasmabereich einer zweiten Plasmaeinheit einen Abstrahlbereich einer benachbarten zweiten Plasmaeinheit überlappt. Hierdurch ist eine sequentielle Zündung benachbarter zweiter Plasmaeinheiten möglich. Insbesondere überlappen sich die Plasmabereiche von wenigstens zwei benachbarten Plasmaeinheiten, um ein einheitlicheres Gesamtplasma erzeugen zu können.

Die Erfindung wird nachfolgend unter Bezugnahme auf die Zeichnungen näher erläutert; in den Zeichnungen zeigt:
- Figur 1: eine schematische Schnittansicht durch eine Plasma-Behandlungsvorrichtung ;
- Figur 2: eine schematische Querschnittsansicht der Plasma-Behandlungsvorrichtung gemäß Figur 1 mit einer um 90 Grad gedrehten Schnittebene;
- Figur 3: eine schematische Ansicht von unten auf eine Anordnung von Plasmaeinheiten, die in der Anordnung gemäß den Figuren 1 und 2 eingesetzt werden kann;
- Figur 4: eine schematische Ansicht von unten auf eine alternative Anordnung von Plasmaeinheiten, die in der Vorrichtung gemäß den Figuren 1 und 2 eingesetzt werden könnte;
- Figur 5: eine schematische Draufsicht auf unterschiedliche Anordnungsbeispiele für Plasmaeinheiten, die in der Vorrichtung gemäß den Figuren 1 und 2 eingesetzt werden könnte.

In der nachfolgenden Beschreibungen verwendete Orts- bzw. Richtungsangaben beziehen sich primär auf die Darstellung in den Zeichnungen und sollten daher nicht einschränkend gesehen werden. Sie können sich aber auch auf eine bevorzugte Endanordnung beziehen.

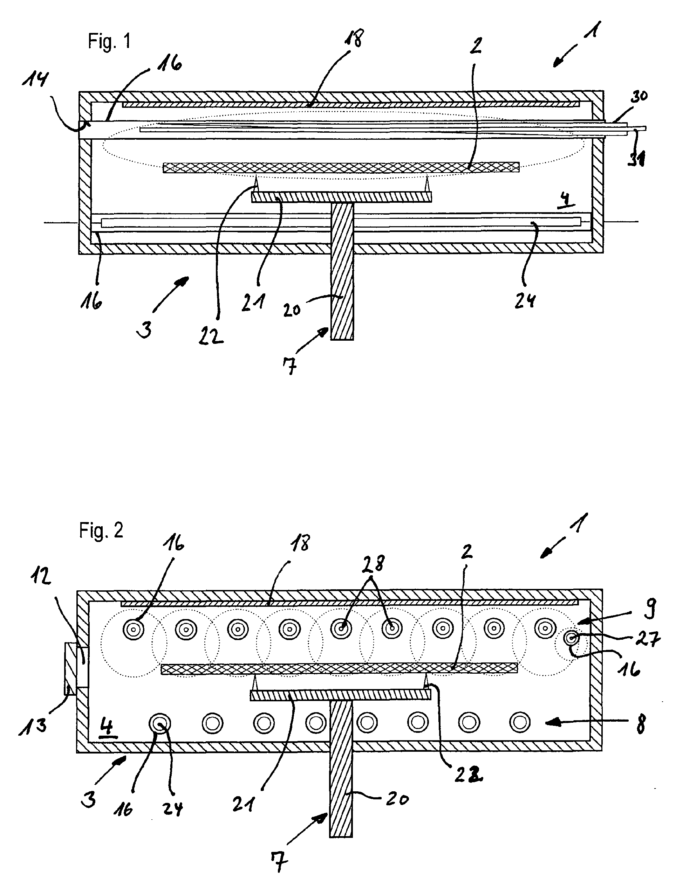

Die Figuren 1 und 2 zeigen jeweils um 90 Grad gedrehte Querschnittsansichten durch eine Plasma-Behandlungsvorrichtung 1 zur Behandlung von flächigen Substraten 2. Die Substrate 2 können dabei insbesondere Halbleitersubstrate sein, deren Oberfläche mittels eines Plasmas geätzt wird oder auf deren Oberfläche ein Schichtwachstum durchgeführt wird. Die Plasma-Behandlungsvorrichtung besteht im Wesentlichen aus einem Gehäuse 3, das im Inneren eine Prozesskammer 4 definiert, einer Substrataufnahmeeinheit 7, einer Heizanordnung 8 sowie einer Plasmaanordnung 9.

Das Gehäuse 3 kann irgendeines geeigneten Typs sein, der eine Prozesskammer 4 im Inneren definiert, in der über gewünschte, nicht näher dargestellte Zu- und Ableitungen vorbestimmte Prozessbedingungen hinsichtlich einer Gaszusammensetzung und Gasdrücken einstellen lässt. In einer Seitenwand des Gehäuses 3 ist eine Be-Entladeöffnung 12 vorgesehen, die über ein bewegliches Türelement 13 verschlossen und geöffnet werden kann.

Ferner besitzt das Gehäuse 3 in gegenüberliegenden Seitenwänden eine Vielzahl von Durchgangsbohrungen 14 zur Aufnahme von Quarzrohren 16, die wiederum zur Aufnahme von Heizeinheiten oder Plasmaeinheiten dienen, wie nachfolgend noch näher erläutert wird. Die Bohrungen 14 sind jeweils paarweise in gegenüberliegenden Seitenwänden derart ausgebildet, dass sich ein Quarzrohr 14 durch die Prozesskammer 4 hindurch erstrecken kann, und zwar senkrecht zu den die Bohrungen 14 aufweisenden Seitenwänden. In einem unteren Bereich der Prozesskammer 14 sind acht solcher Paare von Bohrungen 14 mit der entsprechenden darin aufgenommenen Quarzrohren 16 vorgesehen. In einem oberen Bereich sind insgesamt zehn Paare von Bohrungen 14 in den gegenüberliegenden Seitenwänden des Gehäuses 3 ausgebildet. Dabei liegen neun dieser Paare auf einer Linie, während ein weiteres Paar hierzu nach unten, d.h. zur Mitte der Prozesskammer hin versetzt ist. Auch in diesen Bohrungen sind jeweils Quarzrohre 16 aufgenommen.

An einer oberen Wand des Gehäuses 3 ist an der Innenseite, d.h. innerhalb der Prozesskammer 4 ein Abdeckelement 18 vorgesehen, um die Gehäuseinnenwand gegenüber einem durch die Plasmaanordnung 9 erzeugten Plasma zu schützen.

Im Boden des Gehäuses 3 ist eine Durchführöffnung für eine Tragwelle 20 der Substrathalteanordnung 7 vorgesehen. Die Substrathalteanordnung besteht im Wesentlichen aus einer sich vertikal erstreckenden Tragwelle 20, einer sich horizontal erstreckenden Tragplatte 21 sowie Auflageelementen 22. Die Tragwelle 20 erstreckt sich durch den Boden des Gehäuses 3 und kann außerhalb des Gehäuses 3 zum Beispiel mit einem Antriebsmotor verbunden sein, um die Tragwelle um ihre Längsachse zu drehen und/oder in Vertikalrichtung zu verschieben. Um eine gasdichte Durchführung der Tragwelle 20 durch das Gehäuse 3 zu ermöglichen, können entsprechende Abdichtmechanismen, wie beispielsweise ein Balgenmechanismus im Bereich der Durchführung vorgesehen sein. Die Tragwelle 20 kann beispielsweise aus einem für elektromagnetische Strahlung der Heizanordnung 8 im Wesentlichen transparenten Material, wie beispielsweise Quarz, aufgebaut sein. Alternativ könnte die Tragwelle 20 jedoch auch eine hoch reflektierende Oberfläche aufweisen.

Die Tragwelle 20 trägt an ihrem oberen Ende die Tragplatte 21, die über die Tragwelle sowohl in Vertikalrichtung höhenverstellbar ist, als auch um eine Längsachse der Tragwelle 20 drehbar ist. Die Tragplatte 21 ist vorzugsweise aus einem für die elektromagnetische Strahlung der Heizanordnung 8 im Wesentlichen transparenten Material aufgebaut. Auf einer Oberseite der Tragplatte 21 ist eine Vielzahl der Auflageelemente 22 vorgesehen, die wiederum aus einem vorzugsweise für die Strahlung der Heizanordnung 8 transparenten Material aufgebaut ist. Die Auflageelemente 22 sind als konisch spitz zulaufende Kegel dargestellt, auf deren Spitze das Substrat 2 aufliegt. Die Auflageelemente 22 halten das Substrat 2 über einen gewissen Abstand beabstandet zur Tragplatte 21. Die Substrat-Halteanordnung könnte insgesamt auch anders aufgebaut sein. Insbesondere könnte die Tragplatte als sogenannter Suszeptor aufgebaut sein, der eine Projektionsfläche entsprechend dem Substrat 2 aufweist, und die elektromagnetische Strahlung der Heizanordnung 8 absorbiert, um selbst aufgeheizt zu werden und darüber das Substrat 2 zu heizen.

Die Heizanordnung 8 besteht im Wesentlichen aus acht Heizlampen 24, die in den acht Quarzrohren 16 im unteren Bereich der Prozesskammer 4 angeordnet sind. Die Heizlampen 24 sind als Stablampen ausgebildet, die sich im Wesentlichen vollständig durch die Prozesskammer 4 hindurch erstrecken. Die Heizlampen 24 können irgendeines beliebigen Typs sein, der für eine Aufheizung des Substrats 2 mittels elektromagnetischer Strahlung geeignet ist, wie beispielsweise Wolfram-Halogenlampen. Obwohl dies nicht näher dargestellt ist, können die Quarzrohre 16 mit einem Kühlmedium, wie beispielsweise Luft durchströmt werden, um die Quarzrohre 16 und die Heizlampen 24 während des Betriebs zu kühlen. Natürlich kann auch eine andere Heizanordnung eingesetzt werden, wie zum Beispiel eine Widerstandsheizanordung, die zum Beispiel in der Tragplatte integriert sein.

Es ist jedoch ein alternativer Aufbau der Heizanordnung 8 denkbar, bei dem beispielsweise eine Anordnung von Heizlampen 24 über eine Quarzplatte gegenüber einem Prozessraum für das Substrat 2 getrennt ist, wie es in der Technik bekannt ist.

Die Plasmaanordnung 9 besteht im Wesentlichen aus einer ersten stabförmigen Plasmaeinheit 27, sowie einer Vielzahl von zweiten stabförmigen Plasmaeinheiten 28. Die ersten und zweiten Plasmaeinheiten 27, 28 sind jeweils in entsprechenden Quarzröhren 16 aufgenommen, die sich im oberen Bereich der Prozesskammer 4 durch diese hindurch erstrecken. Während die zweiten Plasmaeinheiten 28 in den in einer Reihe liegenden Quarzröhren 16 aufgenommen sind, ist die Plasmaeinheit 27 in dem leicht nach unten versetzten Quarzrohr 16 angeordnet (siehe rechtes äußeres Quarzrohr 16 in Figur 2).

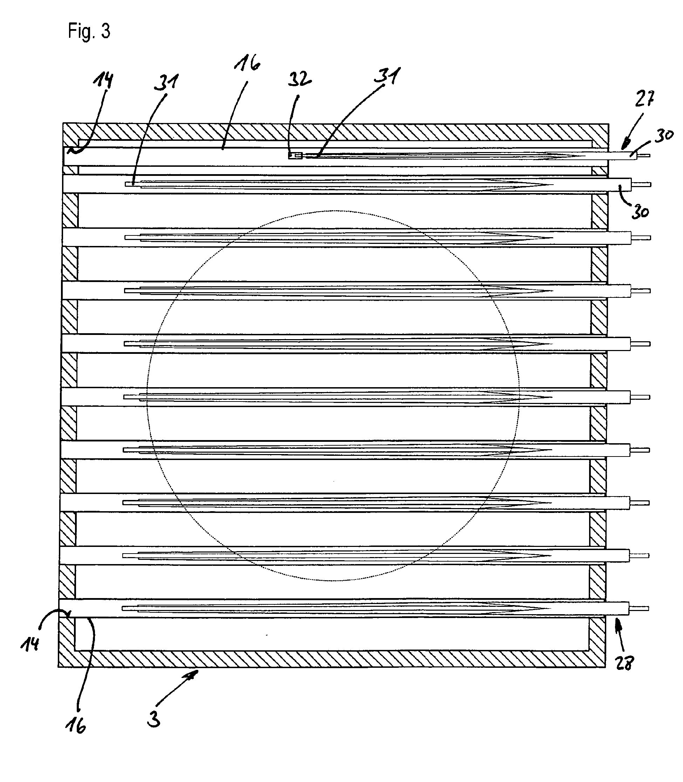

Die Plasmaeinheiten 27 und 28 können jeweils im Wesentlichen denselben Grundaufbau besitzen, wie er beispielsweise in der DE 10 2008 036 766 A1 beschrieben ist. Dabei besitzen die Plasmaeinheiten jeweils einen Hohlleiter 30 sowie einen Innenleiter 31. Der Hohlleiter 30 besitzt, wie in der Ansicht von unten gemäß Figur 3 zu erkennen ist, einen Abschnitt, in dem er den Innenleiter 31 vollständig umgibt, sowie einen daran anschließenden geschlitzten Bereich, in dem der Innenleiter allmählich freigelegt wird, bis ein freies Ende des Innenleiters ganz frei liegt. Die Plasmaeinheiten 27 und 28 sind jeweils des Typs, der von einer Seite (rechts, siehe Figur 1) mit Energie beaufschlagt wird. Am freien Ende des Innenleiters 31 der ersten Plasmaeinheit 27 ist ferner ein Resonator 32 (siehe Figur 3) vorgesehen, um eine Zündung eines Plasmas im Bereich der ersten Plasmaeinheit zu fördern.

Für den genauen Aufbau der Plasmaeinheiten wird auf die DE 10 2008 036 766 A1 hingewiesen, die insofern zum Gegenstand der vorliegenden Erfindung gemacht wird, um Wiederholungen zu vermeiden.

Wie in der Darstellung gemäß den Figuren 2 und 3 zu erkennen ist, ist die erste Plasmaeinheit 27 kleiner dargestellt, als die zweiten Plasmaeinheiten 28. Hierdurch soll angedeutet werden, dass die erste Plasmaeinheit 27 eine geringere Leistung, insbesondere eine geringere Zündleistung aufweisen kann, als die zweiten Plasmaeinheiten 28. Alternativ ist es allerdings auch möglich, die erste Plasmaeinheit 27 in derselben Art und Weise auszubilden, wie die zweiten Plasmaeinheiten 28. Eine gesonderte Ausführung in der oben beschriebenen Art ist dann von Vorteil, wenn die erste Plasmaeinheit 27 als designierte Zündeinheit eingesetzt wird, wie nachfolgend noch näher erläutert wird.

In den Figuren 1 und 2 ist jeweils ein Plasmabereich der jeweiligen Plasmaeinheiten 27 und 28 in Form einer die jeweilige Plasmaeinheit umgebende gestrichelten Linie angedeutet. Hierdurch soll ein üblicher Ausdehnungsbereich eines Plasmas, das durch eine entsprechende Plasmaeinheit 27, 28 erzeugt wird, angedeutet werden. Ein tatsächlicher Abstrahlungsbereich der Plasmaeinheiten vor einer Zündung eines Plasmas kann weiter gehen, als der dargestellte Plasmabereich, wie der Fachmann erkennen kann.

Die Plasmaeinheiten 27 und 28 sind individuell und/oder gruppenweise ansteuerbar. Insbesondere sind sie hinsichtlich der eingespeisten Leistung und der zeitlichen Ansteuerung individuell und/oder gruppenweise ansteuerbar. Dies gilt insbesondere für die erste Plasmaeinheit 27. Für diesen Zweck ist eine nicht näher dargestellte Steuereinheit, die in entsprechender Weise mit den Plasmaeinheiten verbunden ist vorgesehen.

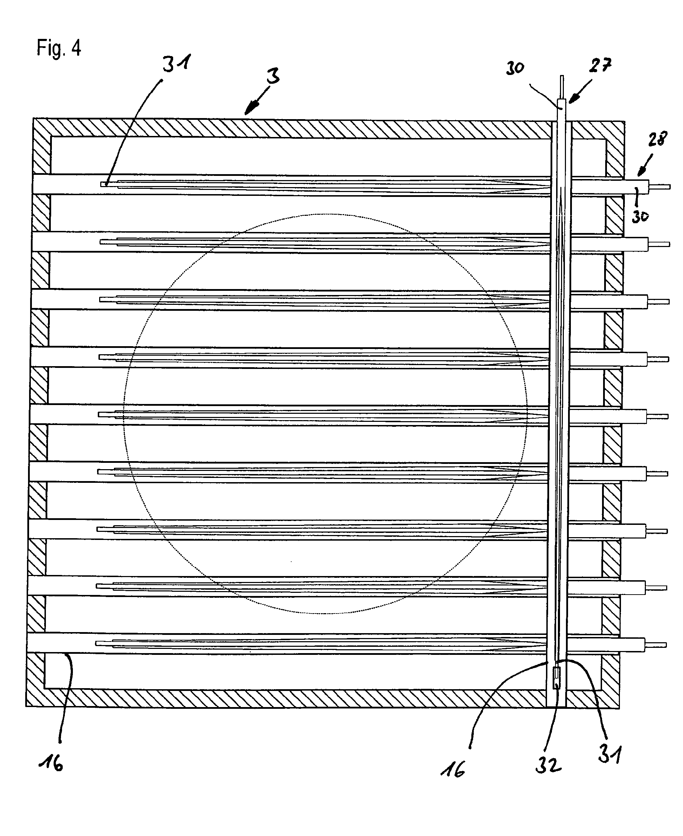

Die Figur 4 zeigt eine alternative Anordnung der Plasmaeinheiten 27 und 28, wobei die zweiten Plasmaeinheiten 28 in der gleichen Art und Weise angeordnet sind, wie in Figur 3 dargestellt ist. Jedoch erstreckt sich die zweite Plasmaeinheit 27 unterhalb und quer zu den ersten Plasmaeinheiten 28. Dabei ist die erste Plasmaeinheit so angeordnet, dass ein durch sie erzeugtes Plasma in einen Abstrahlbereich aller zweiter Plasmaeinheiten 28, wenn diese mit Leistung beaufschlagt werden, liegt. Dabei ist beiden Ausführungsformen gemäß den Figuren 3 und 4 gleich, dass die erste Plasmaeinheit 27 außerhalb eines Projektionsbereichs eines zu behandelnden Substrats liegt, der durch die gestrichelte Linie in den Figuren 3 und 4 angedeutet ist.

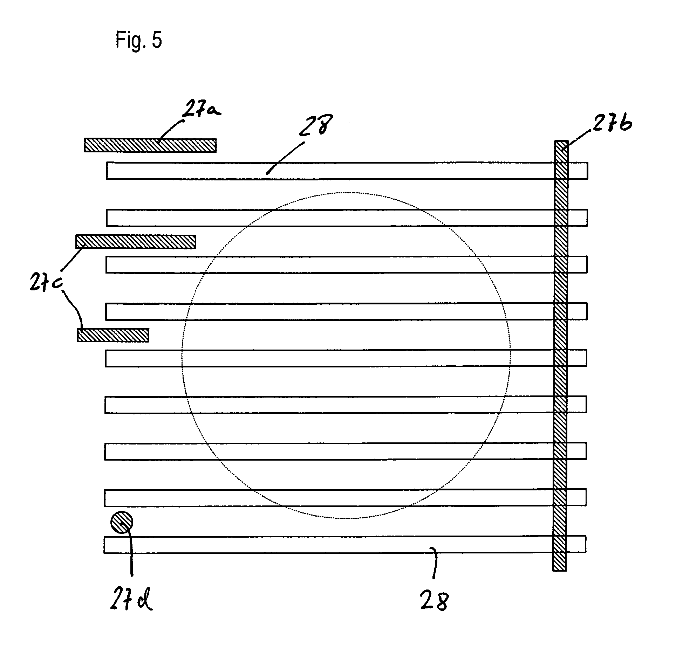

Die Figur 5 zeigt weitere Anordnungsbeispiele der ersten Plasmaeinheit 27 relativ zu zweiten Plasmaeinheiten 28, die wiederum genauso angeordnet sein können, wie in den Figuren 3 und 4 gezeigt ist. Die ersten Plasmaeinheiten 27 sind zur Verbesserung der Darstellung in Figur 5 schraffiert dargestellt. Der gepunktete Kreis in Figur 5 stellt wiederum eine Projektionsfläche eines zu behandelnden Substrats dar.

Bei 27a ist eine Anordnung der ersten Plasmaeinheit gezeigt, die im Wesentlichen der Anordnung gemäß Figur 3 entspricht, d.h. die erste Plasmaeinheit erstreckt sich im Wesentlichen parallel zu den zweiten Plasmaeinheiten 28 und liegt benachbart zu einer außen liegenden zweiten Plasmaeinheit 28.

Bei 27b ist die Anordnung gemäß Figur 4 dargestellt, bei der sich die erste Plasmaeinheit senkrecht zu den zweiten Plasmaeinheiten 28 erstreckt und ein Plasmabereich der ersten Plasmaeinheit den Plasmabereich aller zweiten Plasmaeinheiten überdeckt.

Bei 27c ist die Anordnung einer ersten Plasmaeinheit dargestellt, die sich wiederum im Wesentlichen parallel zu den zweiten Plasmaeinheiten 28 erstreckt, jedoch kürzer ausgebildet ist und darüber hinaus zwischen zwei benachbarten Plasmaeinheiten 28 angeordnet ist. Die ersten Plasmaeinheiten können dabei insbesondere auch oberhalb der ersten Plasmaeinheiten angeordnet sein, solange ihr Plasmabereich einen Abstrahlbereich der benachbarten zweiten Plasmaeinheiten 28 überlappt.

Bei 27d ist wiederum eine erste Plasmaeinheit dargestellt, die sich senkrecht zur Blattebene zwischen zwei benachbarten zweiten Plasmaeinheiten 28 erstreckt.

Die ersten und zweiten Plasmaeinheiten 27, 28 können eines unterschiedlichen Grundtyps sein und insbesondere können sie unterschiedliche Zündleistungen aufweisen. Insbesondere kann die erste Plasmaeinheit 27 eine wesentlich geringere Zündleistung aufweisen, als die Zündleistung der zweiten Plasmaeinheiten 28. Als wesentlich kleiner wird hier eine Zündleistung von maximal 70% der Zündleistung der zweiten Plasmaeinheiten, vorzugsweise von maximal 50% der Zündleistung der zweiten Plasmaeinheiten angesehen. Bevorzugt sollte die Zündleistung der ersten Plasmaeinheit 27 maximal 20% oder gar kleiner gleich 10% der Zündleistung der zweiten Plasmaeinheiten 28 aufweisen.

Bei den unterschiedlichen Darstellungen sind die ersten Plasmaeinheiten jeweils so dargestellt, dass sie einen Projektionsbereich des Substrats 2 nicht überlappen. Obwohl dies vorteilhaft sein kann, um Zündeffekte auf einer Substratoberfläche zu minimieren, ist es auch möglich eine solche Überlappung zuzulassen. Dabei kann es von Vorteil sein, die erste Plasmaeinheit weiter beabstandet zum Substrat vorzusehen, als die zweiten Plasmaeinheiten. Je nach tatsächlicher Zündleistung der ersten Plasmaeinheit 27 ist dies aber nicht unbedingt notwendig, insbesondere dann nicht, wenn die Zündleistung der ersten Plasmaeinheit in einem Leistungsbereich liegt, in dem die zweiten Plasmaeinheiten ein Plasma für eine Behandlung des Substrats 2 erzeugen.

Bei den zuvor beschriebenen Ausführungsformen ist jeweils eine erste Plasmaeinheit 27 beschrieben worden, die sich hinsichtlich ihrer Anordnung, Größe und sonstigem von zweiten Plasmaeinheiten unterscheidet. Es ist jedoch auch möglich, auf eine solche gesonderte erste Plasmaeinheit 27 vollständig zu verzichten, und nur die Anordnung von zweiten Plasmaeinheiten 28 vorzusehen, sofern diese individuell und oder gruppenweise ansteuerbar sind.

Nachfolgend wird der Betrieb der Vorrichtung 1 unter Bezugnahme auf die Figuren näher erläutert.

Zunächst wird ein zu behandelndes Substrat in die Prozesskammer 4 geladen und in einer Position gehalten und, wie sie in den Figuren 1 und 2 dargestellt ist. Die Prozesskammer 4 wird über das Türelement 13 verschlossen, und es wird eine gewünschte Gasatmosphäre innerhalb der Prozesskammer 4 eingestellt. Über die Heizanordnung 8 kann das Substrat 2 auf eine gewünschte Prozesstemperatur innerhalb der Prozesskammer 4 erwärmt werden. Durch eine Vorheizung des Substrates (∼400 °C) kann auch schon die die Plasmazündleistung reduziert werden. Direkt über dem Substrat ist das Gas ähnlich heiß wie das Substrat in einem Kaltwandreaktor und dadurch wäre ein Plasma auch aus diesem Grund mit geringerer Leistung zündbar. Vorzugsweise kann das Substrat auf eine Temperatur im Bereich zwischen 200 und 600°C, vorzugsweise auf eine Temperatur um 400°C ±50°C vorgeheizt werden.

Wenn die Plasmabehandlung beginnen soll, und eine entsprechende Gasatmosphäre in der Prozesskammer 4 vorhanden ist, wird zunächst die erste Plasmaeinheit 27 mit einer Zündleistung beaufschlagt, um ein Plasma im Plasmabereich der ersten Plasmaeinheit 27 zu zünden. Wenn das Plasma gezündet ist, oder auch schon vorher, wird wenigstens die benachbart zur ersten Plasmaeinheit 27 liegende Plasmaeinheit 28 mit einer Leistung beaufschlagt, die wesentlich geringer ist, als ihre Zündleistung, die aber ausreicht ein Plasma innerhalb des Plasmabereichs der zweiten Plasmaeinheit 28 aufrecht zu erhalten. Insbesondere kann die zweite Plasmaeinheit 28 mit einer Leistung beaufschlagt werden, mit der das Plasma für eine anfängliche Behandlung beaufschlagt werden soll. Während der Behandlung des Substrats 2 kann die Leistung dann noch entsprechend geändert werden, aber am Anfang kann direkt die gewünschte Leistung eingestellt werden.

Dadurch, dass die erste Plasmaeinheit 27 schon gezündet hat und der Plasmabereich der ersten Plasmaeinheit einen Abstrahlbereich der direkt benachbarten zweiten Plasmaeinheit 28 überlappt, entsteht auch benachbart zu dieser zweiten Plasmaeinheit 28 ein entsprechendes Plasma. Dieses Plasma kann dann in entsprechender Weise über die gesamten zweiten Plasmaeinheiten 28 ausgebreitet werden, beispielsweise von rechts nach links gemäß Figur 2. Hierbei können die zweiten Plasmaeinheiten 28 jeweils mit einer Leistung beaufschlagt werden, die wesentlich geringer ist als ihre Zündleistung. Insbesondere können sie direkt mit der Leistung beaufschlagt werden, die für eine anfängliche Substratbehandlung geeignet ist. Das Anlegen einer Zündleistung an die zweiten Plasmaeinheiten 28, welche zunächst sehr hochenergetische Plasmateilchen erzeugen würden, ist zu keinem Zeitpunkt notwendig, da die jeweiligen Plasmen im Bereich der zweiten Plasmaeinheiten 28 durch benachbarte Plasma gezündet werden.

Hierdurch lassen sich von Anfang an hoch qualitative Schichten mithilfe von Plasmen erzeugen, ohne die Substratoberfläche beim Zündvorgang zu schädigen.

Insbesondere kann eine fortschreitende Plasmafront erzeugt werden, die gegebenenfalls zu einer Reinigung der Substratoberfläche beitragen kann.

Bei einer Anordnung der Plasmaeinheiten gemäß Figur 4 wäre es möglich, nach der Zündung der ersten Plasmaeinheit 27 alle weiteren Plasmaeinheiten im Wesentlichen gleichzeitig zu zünden, da bei der sich quer erstreckenden Anordnung der Plasmaeinheit 27 zu den Plasmaeinheiten 28, deren Plasmabereich die Abstrahlbereiche aller zweiten Plasmaeinheiten 28 überdecken würde.

Wie der Fachmann erkennen kann, kann die Plasmabehandlung kontrolliert von Anfang an mit einer gewünschten Plasmaleistung erfolgen. Nach der sanften Zündung kann die Plasmaleistung mit beliebigen mathematischen Funktionen erhöht oder erniedrigt (geändert) werden.

Die Plasmaeinheiten können natürlich auch noch anders angeordnet sein, und es ist auch möglich eine Abstandseinstellung zwischen den Plasmaeinheiten und dem Substrat vorzusehen, wie es beispielsweise in der nicht vorveröffentlichten DE 10 2009 060 230 dargestellt ist.

Durch die Verwendung einer designierten Zündantenne, wie der ersten Plasmaeinheit 27 ist es möglich, während des Zündvorgangs deutlich weniger hochenergetische Plasmateilchen zu erzeugen, da die designierte Zündantenne mit einer geringeren Zündleistung ausgestattet sein kann, wie die Haupteinheiten, d.h. die zweiten Plasmaeinheiten 28. Durch eine entsprechende räumliche Anordnung außerhalb eines Projektionsbereichs des zu behandelnden Substrats lässt sich der Anteil der trotzdem noch erzeugten energiereichen Plasmateilchen, welche auf das Substrat treffen, wesentlich minimieren. Durch entsprechende Ansteuerung der zweiten Plasmaeinheiten lässt sich die anfängliche Wachstumsrate einer zu bildenden Schicht auf dem Substrat stark reduzieren, wodurch sich hochwertigere Schichten hinsichtlich des charge-tobreak-down Q_{bd} oder der interface state density Dᵢₜ ergibt.

Alternativ zur Verwendung einer designierten Zündantenne, wie der ersten Plasmaeinheit 27 ist es auch möglich nur eine oder einzelne der zweiten Plasmaeinheiten zur Zündung zu verwenden. Dies kann durch Implementierung einer Einzel- oder Gruppenansteuerung der zweiten Plasmaeinheiten realisiert werden. Wenn beispielsweise in Figur 2 die erste Plasmaeinheit 27 nicht vorgesehen wäre, könnten zum Beispiel die beiden äußeren, außerhalb des Projektionsbereichs des Substrats 2 liegenden zweiten Plasmaeinheiten 28 zu Beginn des Prozesses mit Zündleistung beaufschlagt werden, um in deren Bereich ein Plasma zu zünden. Die übrigen zweiten Plasmaeinheiten könnten dann wiederum mit einer wesentlich geringeren Leistung als der Zündleistung beaufschlagt werden, um wiederum eine fortschreitende Plasmafront vorzusehen. Diese würde in diesem Beispiel von außen nach innen verlaufen. Natürlich wäre es in gleicher Weise möglich, nur eine der äußeren zweiten Plasmaeinheiten 28 mit Zündleistung zu beaufschlagen, um dann eine von einer zur anderen Seite fortschreitende Plasmafront zu erreichen. Je nach Anordnung der Plasmaelektroden und entsprechender Ansteuerung ist es natürlich auch möglich, eine Plasmafront von der Mitte nach außen hin zu erzeugen.

Bevorzugt sollte jedoch jeweils die für die anfängliche Zündung eines Plasmas verwendete Plasmaelektrode außerhalb eines Projektionsbereichs des zu behandelnden Substrats liegen. Wie oben beschrieben kann ein Plasma mit kleinen Plasmaleistungen im Hauptfeld der zweiten Plasmaeinheiten gezündet werden. Dabei ist auch eine besonders rasche Zündung des jeweiligen Plasmas im Bereich der zweiten Plasmaeinheiten 28 möglich, da diese jeweils durch ein benachbartes Plasma rasch gezündet werden. Daher eignet sich der vorliegende Aufbau insbesondere auch für das Anlegen eines gepulsten Plasmas während der Substratbehandlung, wodurch sich die Durchschnittsleistung gegenüber sonstigen gepulsten Plasmen wesentlich verringern lässt.

Darüber hinaus ist auch ein schnelleres Pulsen möglich, was zu einer rascheren Erfrischung der reaktiven Spezies führt. Bei dem Pulsvorgang sollte möglichst jeweils eine, insbesondere die designierte Zündantenne, d.h. die erste Plasmaeinheit 27, im Wesentlichen kontinuierlich betrieben werden. Alternativ ist es natürlich auch möglich eine oder mehrere der zweiten Plasmaeinheiten 28 kontinuierlich zu betreiben während die anderen zweiten Plasmaeinheiten 28 gepulst werden. Natürlich wäre auch ein wechselseitiges Pulsen der Plasmaeinheiten möglich, solange noch immer ein Plasma vorhanden ist, um eine erneute Zündung des Plasmas jeweils mit einer Leistung zu erreichen, die wesentlich unter der Zündleistung der entsprechenden Plasmaeinheit liegt.

Die Erfindung wurde zuvor anhand bevorzugter Ausführungsformen näher erläutert, ohne auf die konkret dargestellten Ausführungsformen beschränkt zu sein.

## Patentansprüche

1. Verfahren zum Behandeln eines Substrats (2), bei dem ein Plasma über eine Vielzahl von Plasmaeinheiten (27, 28) erzeugt wird, wobei das Verfahren die folgenden Schritte aufweist:
Einspeisen einer Zündleistung in wenigstens eine erste Plasmaeinheit (27), um benachbart hierzu in einem ersten Plasmabereich ein Plasma zu erzeugen;
Einspeisen einer Leistung in wenigstens eine zweite Plasmaeinheit (28), wobei die eingespeiste Leistung wesentlich kleiner ist als die Zündleistung der zweiten Plasmaeinheit (28), aber ausreicht, um ein einmal gezündetes Plasma benachbart zur zweiten Plasmaeinheit (28) aufrecht zu erhalten, wobei die zweite Plasmaeinheit (28) derart benachbart zur ersten Plasmaeinheit (27) liegt, dass der erste Plasmabereich einen Abstrahlbereich der zweiten Plasmaeinheit (28) überlappt, Zünden eines Plasmas im Plasmabereich der zweiten Plasmaeinheit (28) mittels des schon gezündeten Plasmas im ersten Plasmabereich und der in die zweite Plasmaeinheit (28) eingespeisten Leistung;
**dadurch gekennzeichnet, dass**
die wenigstens eine erste Plasmaeinheit (27) außerhalb eines Projektionsbereichs des zu behandelnden Substrats liegt; und
die wenigstens eine erste Plasmaeinheit (27) eine Zündleistung besitzt, die wesentlich kleiner ist, als die Zündleistung der wenigstens einen zweiten Plasmaeinheit (28).

2. Verfahren nach Anspruch 1, wobei in wenigstens eine weitere Plasmaeinheit (28) eine Leistung eingespeist wird, die wesentlich kleiner ist als die Zündleistung der weiteren Plasmaeinheit (28), die aber ausreicht, ein einmal gezündetes Plasma benachbart zur weiteren Plasmaeinheit (28) aufrecht zu erhalten, wobei die weitere Plasmaeinheit (28) derart benachbart zur ersten oder zweiten Plasmaeinheit (27, 28) liegt, dass deren Plasmabereich einen Abstrahlbereich der weiteren Plasmaeinheit (28) überlappt;
Zünden eines Plasmas im Plasmabereich der weiteren Plasmaeinheit (28) mittels des gezündeten Plasmas im Plasmabereich der ersten oder zweiten Plasmaeinheit (27, 28) und der in die weitere Plasmaeinheit (28) eingespeisten Leistung.

3. Verfahren nach Anspruch 1 oder 2, wobei eine Vielzahl von Plasmaeinheiten (28) sequentiell von einer Seite des zu behandelnden Substrats zur gegenüberliegenden in der obigen Weise gezündet wird.

4. Verfahren nach einem der Ansprüche 1 bis 3, wobei eine Vielzahl von Plasmaeinheiten (28) sequentiell von der Mitte des zu behandelnden Substrats in entgegengesetzte Richtungen zum Rand des Substrats in der obigen Weise gezündet wird.

5. Verfahren nach einem der vorhergehenden Ansprüche, wobei der erste Plasmabereich einen Abstrahlbereich von wenigstens zwei zweiten Plasmaeinheiten (28) überlappt und wenigstens zwei zweite Plasmaeinheiten (28) gleichzeitig in der obigen Weise gezündet werden.

6. Verfahren nach einem der vorhergehenden Ansprüche, wobei die wenigstens eine erste Plasmaeinheit (27) weiter von der zu behandelnden Oberfläche des Substrats entfernt ist als die zweite oder eine weitere Plasmaeinheit (28).

7. Verfahren nach einem der vorhergehenden Ansprüche, wobei die wenigstens eine erste Plasmaeinheit (27) eine Zündleistung besitzt, die wesentlich kleiner ist, als die Zündleistung der wenigstens einen weiteren Plasmaeinheit(en).

8. Verfahren nach einem der vorhergehenden Ansprüche, wobei wenigstens ein Teil der Plasmaeinheiten (28) während der Behandlung eine Substrats gepulst betrieben wird, wobei für jede erneute Zündung eines Plasmas im jeweiligen Plasmabereich einer gepulsten Plasmaeinheit (28) diese mit eine Leistung beaufschlagt wird, die wesentlich kleiner ist als die Zündleistung der Plasmaeinheit (28), die aber ausreicht, ein einmal gezündetes Plasma benachbart zur Plasmaeinheit (28) aufrecht zu erhalten, wobei die Zündung jeweils über ein bestehendes benachbartes Plasma und die jeweils eingespeiste Leistung erfolgt.

9. Verfahren nach Anspruch 8, wobei wenigstens eine Plasmaeinheit, insbesondere die wenigstens eine erste Plasmaeinheit (27), während des Pulsierens der anderen Plasmaeinheit(en) (28) kontinuierlich betrieben wird.

10. Verfahren nach einem der Vorhergehenden Ansprüche, wobei das zu behandelnde Substrat vorgeheizt wird, insbesondere auf eine Temperatur im Bereich zwischen 200 und 600°C, vorzugsweise auf eine Temperatur um 400°C ±50°C.

11. Vorrichtung (1) zum Behandeln eines Substrats mittels eines Plasmas, die folgendes aufweist:
eine Vielzahl von benachbarten Plasmaeinheiten (27, 28) zum jeweiligen Erzeugen eines Plasmas in einem Plasmabereich der Plasmaeinheiten (27, 28), wobei die Plasmaeinheiten (27, 28) so angeordnet sind, dass der Plasmabereich wenigstens einer ersten Plasmaeinheit (27) einen Abstrahlbereich wenigstens einer benachbarten zweiten Plasmaeinheit (28) überlappt; und
eine Steueranordnung, die geeignet ist wenigstens die ersten und zweiten Plasmaeinheiten (27, 28) unabhängig voneinander anzusteuern;
**dadurch gekennzeichnet, dass**
die wenigstens eine erste Plasmaeinheit (27) außerhalb eines Projektionsbereichs des zu behandelnden Substrats liegt und eine Zündleistung besitzt, die wesentlich kleiner ist, als die Zündleistung der wenigstens einen zweiten Plasmaeinheit.

12. Vorrichtung (1) nach Anspruch 11, wobei die wenigstens eine erste Plasmaeinheit (27) so angeordnet ist, dass ihr Plasmabereich einen Abstrahlbereich von wenigstens zwei benachbarten zweiten Plasmaeinheiten (28) überlappt.

13. Vorrichtung (1) nach einem der Ansprüche 11 bis 12, wobei eine Vielzahl von zweiten Plasmaeinheiten (28) vorgesehen ist, die benachbart derart angeordnet sind, dass ein jeweiliger Plasmabereich einer zweiten Plasmaeinheit (28) einen Abstrahlbereich einer benachbarten zweiten Plasmaeinheit (28) überlappt.

14. Vorrichtung (1) nach einem der Ansprüche 11 bis 13, wobei sich die Plasmabereiche von wenigstens zwei benachbarten Plasmaeinheiten (28) überlappen.

15. Vorrichtung (1) nach einem der Ansprüche 11 bis 14, wobei die zweiten Plasmaeinheiten (28) jeweils stabförmige Mikrowellenantennen aufweisen.

## Claims

1. A method for the treatment of a substrate (2), in which a plasma is generated via a plurality of plasma units (27, 28), the method comprising the following steps:
supplying an ignition power to at least one first plasma unit (27) in order to generate a plasma in a first plasma area adjacent hereto;
supplying a power to at least a second plasma unit (28), wherein the supplied power is substantially smaller than the ignition power of the second plasma unit (28), but which is sufficient in order to sustain a ignited plasma adjacent to the second plasma unit (28), wherein the second the plasma unit (28) is arranged adjacent to the first plasma unit (27), such that the first plasma area overlaps a radiation area of the second plasma unit (28);
igniting a plasma in the plasma area of the second plasma unit (28) by means of the ignited plasma in the first plasma area and the power supplied to the second plasma unit (28);
**characterized in that**
the at least one first plasma unit (27) is arranged outside of an area of projection of the substrate to be treated; and
the at least one first plasma unit (27) has an ignition power, which is substantially smaller than the ignition power of the at least one second plasma unit (28).

2. The method according to claim 1, wherein to at least one further plasma unit (28) a power is supplied, which is substantially smaller than the ignition power of the further plasma unit (28), but which is sufficient to sustain a plasma ignited adjacent to the further plasma unit (28), wherein the further plasma unit (28) is arranged adjacent to the first or second plasma unit (27, 28) such that their plasma area overlaps an radiation area of the further plasma unit (28);
igniting a plasma in the plasma area of the further plasma unit (28) by means of the ignited plasma in the plasma area of the first or second plasma unit (27, 28) and the power supplied to the further plasma unit (28).

3. The method according to claim 1 or 2 wherein a plurality of plasma units (28) is sequentially ignited in the above manner from one side of the substrate to be treated to the other side.

4. Method according to anyone of claims 1 to 3 wherein a plurality of plasma units (28) is sequentially ignited in the above manner starting from the middle of the substrate to be treated in opposite directions towards the edge of the substrate.

5. Method according to anyone of the preceding claims, wherein the first plasma area overlaps an radiation area of at least two second plasma units (28) and wherein two second plasma units (28) are simultaneously ignited in the above referenced manner.

6. Method according to anyone of the preceding claims, wherein the at least one first plasma unit (27) is further distanced from the surface of the substrate to be treated than the second or a further plasma unit (28).

7. Method according to anyone of the preceding claims, wherein the at least one first plasma unit (27) has a ignition power, which is substantially smaller than the ignition power of the at least one further plasma unit(s).

8. Method according to anyone of the preceding claims, wherein at least a portion of the plasma units (28) is operated in a pulsed manner during the treatment of a substrate, wherein for each reignition of a plasma in the respective plasma area of a pulse plasma unit (28) the respective plasma unit is supplied with power, which is substantially smaller than the ignition power of the respective plasma unit (28), but which is sufficient to sustain a once ignited plasma adjacent to the plasma unit (28), wherein the ignition is achieved via an active adjacent plasma and the respective supplied power.

9. Method according to claim 8, wherein at least one plasma unit in particular the at least first plasma unit (27) is continuously operated during the pulsing of the other plasma unit(s) (28).

10. Method according to anyone of the preceding claims, wherein the substrate to be treated is preheated, in particular to a temperature in the range of 200 to 600 °C, preferably to a temperature of about 400 °C +/-50 °C.

11. An apparatus 1 for the treatment of substrates by means of a plasma, the apparatus comprising:
a plurality of adjacent plasma units (27, 28) for the respective generation of a plasma in the plasma area of the plasma units (27, 28), wherein the plasma units (27, 28) are arranged such that the plasma area of at least one first plasma unit (27) overlaps a radiation area of at least one adjacent second plasma unit (28); and
a control unit which is configured to control the at least first and second plasma units (27, 28) independently of each other;
**characterized in that**
the at least one first plasma unit (27) is arranged outside of an projection area of the substrate to be treated and comprises an ignition power, which is substantially smaller than the ignition power of the at least one second plasma unit.

12. Apparatus (1) according to claim 11, wherein the at least one first plasma unit (27) is arranged such that its plasma area overlaps a radiation area of at least two adjacent second plasma units (28).

13. Apparatus (1) according to one of claims 11 to 12 wherein a plurality of second plasma units (28) is provided, which are arranged adjacent to each other such that a respective plasma area of a second plasma unit (28) overlaps a radiation area of an adjacent second plasma unit (28).

14. Apparatus (1) according to anyone of claims 11 to 13, wherein the plasma areas of at least two adjacent plasma units (28) overlap.

15. Apparatus (1) according to anyone of claims 11 to 14, wherein the second plasma units (28) each comprise rod shaped microwave antennas.

## Revendications

1. Procédé pour le traitement d'un substrat (2), dans lequel un plasma est produit par l'intermédiaire d'une pluralité de modules plasma (27, 28), le procédé comprenant les étapes suivantes :
fournir une énergie d'allumage à au moins un premier module plasma (27) afin de produire un plasma dans une première région de plasma adjacente à celui-ci ;
fournir de l'énergie à au moins un deuxième module plasma (28), l'énergie fournie étant sensiblement plus faible que l'énergie d'allumage du deuxième module plasma (28), mais suffisante pour maintenir allumé un plasma adjacent au deuxième module plasma (28), le deuxième module plasma (28) étant agencé adjacent au premier module plasma (27), de sorte que la première région de plasma chevauche une région de rayonnement du deuxième module plasma (28) ;
allumer un plasma dans la région de plasma du deuxième module plasma (28) au moyen du plasma allumé dans la première région de plasma et de l'énergie fournie au deuxième module plasma (28) ;
**caractérisé en ce que**
ledit au moins un premier module plasma (27) est agencé à l'extérieur d'une région de projection du substrat à traiter ; et
ledit au moins un premier module plasma (27) a une énergie d'allumage qui est sensiblement inférieure à l'énergie d'allumage dudit au moins un deuxième module plasma (28).

2. Procédé selon la revendication 1, dans lequel de l'énergie est fournie à au moins un autre module plasma (28), qui est sensiblement inférieure à l'énergie d'allumage de l'autre module plasma (28), mais qui est suffisante pour maintenir allumé un plasma adjacent à l'autre module plasma (28), l'autre module plasma (28) étant agencé adjacent au premier ou au deuxième module plasma (27, 28) de telle sorte que leurs régions de plasma chevauchent une région de rayonnement de l'autre module plasma (28) ;
allumer un plasma dans la région de plasma de l'autre module plasma (28) au moyen du plasma allumé dans la région de plasma du premier ou du deuxième module plasma (27, 28) et de l'énergie fournie à l'autre module plasma (28).

3. Procédé selon la revendication 1 ou 2, dans lequel plusieurs modules plasma (28) sont allumés séquentiellement de la manière susmentionnée à partir d'un côté donné du substrat à traiter jusqu'à l'autre côté.

4. Procédé selon l'une quelconque des revendications 1 à 3, dans lequel plusieurs modules plasma (28) sont allumés séquentiellement de la manière susmentionnée en commençant par le milieu du substrat à traiter, dans des directions opposées en direction du bord du substrat.

5. Procédé selon l'une quelconque des revendications précédentes, dans lequel la première région de plasma chevauche une région de rayonnement d'au moins deux deuxièmes modules plasma (28) et dans lequel deux deuxièmes modules plasma (28) sont allumés simultanément de la manière susmentionnée.

6. Procédé selon l'une quelconque des revendications précédentes, dans lequel ledit au moins un premier module plasma (27) est encore plus éloigné de la surface du substrat à traiter que le deuxième ou qu'un autre module plasma (28).

7. Procédé selon l'une quelconque des revendications précédentes, dans lequel ledit au moins un premier module plasma (27) a une énergie d'allumage qui est sensiblement plus faible que l'énergie d'allumage dudit au moins un autre module plasma.

8. Procédé selon l'une quelconque des revendications précédentes, dans lequel au moins une partie des modules plasma (28) est actionnée de manière pulsée pendant le traitement d'un substrat, dans lequel, pour chaque ré-allumage d'un plasma dans la région de plasma respective d'un module plasma à impulsions (28), le module plasma respectif est alimenté avec une énergie qui est sensiblement plus faible que l'énergie d'allumage du module plasma respectif (28), mais qui est suffisante pour maintenir un plasma déjà allumé adjacent au module plasma (28), dans lequel l'allumage est obtenu par l'intermédiaire d'un plasma adjacent actif et de l'énergie respective fournie.

9. Procédé selon la revendication 8, dans lequel au moins un module plasma, en particulier ledit au moins un premier module plasma (27), est actionné en continu pendant l'actionnement en impulsions des autres modules plasma (28).

10. Procédé selon l'une quelconque des revendications précédentes, dans lequel le substrat à traiter est préchauffé, en particulier à une température comprise entre 200 et 600 °C, de préférence à une température d'environ 400 °C +/- 50 °C.

11. Dispositif 1 pour le traitement de substrats au moyen d'un plasma, le dispositif comprenant :
une pluralité de modules plasma adjacents (27, 28) pour la production respective d'un plasma dans la région de plasma des modules plasma (27, 28), les modules plasma (27, 28) étant agencés de telle sorte que la région de plasma d'au moins un premier module plasma (27) chevauche une région de rayonnement d'au moins un deuxième module plasma (28) adjacent ; et
un module de commande qui est agencé pour contrôler lesdits au moins un premier et deuxième modules plasma (27, 28) indépendamment entre eux ;
**caractérisé en ce que**
ledit au moins un premier module plasma (27) est agencé à l'extérieur d'une région de projection du substrat à traiter et a une énergie d'allumage qui est sensiblement plus faible que l'énergie d'allumage dudit au moins un deuxième module plasma.

12. Dispositif (1) selon la revendication 11, dans lequel ledit au moins un premier module plasma (27) est agencé de telle sorte que sa région de plasma chevauche une région de rayonnement d'au moins deux deuxièmes modules plasma (28) adjacents.

13. Dispositif (1) selon l'une quelconque des revendications 11 à 12, dans lequel sont prévus plusieurs deuxièmes modules plasma (28), qui sont agencés adjacents entre eux de telle sorte qu'une région de plasma respective d'un deuxième module plasma (28) chevauche une région de rayonnement d'un deuxième module plasma (28) adjacent.

14. Dispositif (1) selon l'une quelconque des revendications 11 à 13, dans lequel les régions de plasma d'au moins deux modules plasma (28) adjacents se chevauchent.

15. Dispositif (1) selon l'une quelconque des revendications 11 à 14, dans lequel les deuxièmes modules plasma (28) comprennent chacun des antennes micro-ondes en forme de tiges.
